# EUROPÄISCHE PATENTSCHRIFT

(11) **EP 1 370 486 B1**
(45) Veröffentlichungstag und Bekanntmachung des Hinweises auf die Patenterteilung: **01.12.2010**
(21) Anmeldenummer: 02729963.5
(22) Anmeldetag: 06.03.2002
(51) Int. Cl.: C01B 13/34, C01G 3/00, C01G 29/00, H01L 39/24, C04B 35/45

(54) **VERFAHREN ZUR HERSTELLUNG VON MULTINÄREN METALLOXIDPULVERN IN EINEM PULSATIONSREAKTOR**
METHOD FOR PRODUCING MULTINARY METAL OXIDE POWDERS IN A PULSED REACTOR
PROCEDE DE PRODUCTION DE POUDRES D'OXYDE METALLIQUE MULTICOMPOSANTS DANS UN REACTEUR PULSE

(30) Priorität: 13.03.2001 DE 10111938
(43) Veröffentlichungstag der Anmeldung: 17.12.2003
(73) Patentinhaber: IBU-tec advanced materials AG, 99425 Weimar (DE)
(72) Erfinder: REMKE, Stefan, 53113 Bonn (DE); MÜLLER, Bernd, 64673 Zwingenberg (DE); RIEDEL, Günter, 65779 Kelkheim (DE); AMBROSIUS, Stefan, 99439 Berlstedt (DE); DAHM, Bernd, 99423 Weimar (DE)
(74) Vertreter: Finger, Catrin
(86) Internationale Anmeldenummer: PCT/EP2002/002408
(87) Internationale Veröffentlichungsnummer: WO 2002/072471

(56) Entgegenhaltungen:
- EP-A- 0 905 104
- WO-A-99/38819
- DE-C- 19 608 841
- DE-C- 19 614 430
- SHELUKAR S.D. ET AL: "Continuous Rotary Kiln Calcination of YBaCuO Precursor Powders" IND. ENG. CHEM. RES., Bd. 33, 1994, Seiten 421-427, XP002239301

## Beschreibung

Die vorliegende Erfindung betrifft ein Verfahren zur Herstellung eines feinteiligen, multinären, d.h. mehrere Elemente enthaltenden Metalloxidpulvers, das sich zur Verwendung als Vorläufer von Hochtemperatur-Supraleitern eignet.

Hochtemperatur-Supraleiter-Materialien (HTSL) sind multinäre Oxide mit hohen Anforderungen an die chemische Reinheit, die Homogenität, die definierte Phasenzusammensetzung und die Kristallitgröße sowie die Reproduzierbarkeit. Im Stand der Technik sind einige Verfahren zur Herstellung der entsprechenden mehrphasigen Metalloxidpulver bekannt, aus denen durch weitere Verarbeitung Hochtemperatur-Supraleiter hergestellt werden können, beispielsweise Bulkmaterial durch Pressen, Extrudieren und/oder Sintern, oder Draht- und Bandleiter mittels "Pulver-in-Rohr-Verfahren".

In der EP 0 522 575 A1, EP 0 285 392 A2 und US 5,298,654 wird die Kofällung von in Wasser gelösten Metallverbindungen, z.B. von Nitraten oder Chloriden, beschrieben. Dabei werden aus den Lösungen mit Oxalsäure die wasserunlöslichen oder schwer löslichen Metalloxalatgemische ausgefällt. Die technische Realisierung dieser Prozesse erfordert einen hohen technischen Aufwand sowohl bei der Kofällung wie auch bei der Entsorgung oder Wiederverwendung der entstehenden Abbauprodukte. Die Sprühtrocknung derartiger Mischfällungs-Produkte, die meist nur in geringer Konzentration in der "Mutterlauge" (Größenordnung von 10%) als Feststoff enthalten sind, ist aus energietechnischer Sicht ungünstig. Außerdem können bei der thermischen Entwässerung durch Rückreaktionen flüchtige Produkte entstehen, die mit der Abluft ausgetragen werden und die dadurch die chemische Zusammensetzung der Nachfolgeprodukte in nicht reproduzierbarer Weise beeinflussen.

In anderen Verfahren werden Mischungen wässriger Salzlösungen von den Elementen, die im Supraleiter enthalten sein sollen, einer Sprühpyrolyse unterzogen.

In der WO 89/02871 wird ein Verfahren zur Herstellung von Multielement-Metalloxidpulvern zur Verwendung als Vorläufer für HTSL-Keramiken beschrieben, wobei Metallmischsalzlösungen in einen auf eine Temperatur von 800-1100°C erhitzten Rohrofen gesprüht werden. Bei diesem Verfahren wird einerseits aufgrund der externen elektrischen Beheizung des Rohrofens nur eine geringe Energieausbeute und andererseits nur ein relativ geringer Umsatz zum Mischoxid erreicht.

Die EP 0 371 211 A2 beansprucht ein Spraypyrolyseverfahren zur Herstellung von feinteiligen, homogenen Keramikpulvern, bei dem man eine Lösung oder Suspension von Verbindungen, die die Elemente des herzustellenden Pulvers enthalten, mit Hilfe eines brennbaren Gases, vorzugsweise Wasserstoffgas, in einen Reaktor einsprüht, in dem das Gas verbrannt wird. Die Umwandlung der versprühten Tröpfchen in die Oxid pulver findet in der Flamme bei einer messbaren Temperatur von 1200-1300°C statt. Im Fall der Verwendung von Nitratlösungen ist davon auszugehen, dass auf das System Tröpfchen/Teilchen weitaus höhere Temperaturen einwirken. Die Herstellung von Pulvern für Hochtemperatur-Supraleiter mit definierter Zusammensetzung ist mit diesem Verfahren schwierig, da die Pulver in der Regel auch flüchtige Metalloxide, z.B. Bi- oder Pb-oxide enthalten, die sich in variablen Anteilen verflüchtigen.

In der DE 195 05 133 wird ein Verfahren zur Herstellung hochdisperser oxidischer Pulver beschrieben, wobei ein Aerosol von gelösten oder flüssigen Verbindungen in Sauerstoff einem Knallgasreaktor unter Druck vor der Verbrennung zugeführt wird. Dabei werden ebenfalls sehr hohe Reaktionstemperaturen benötigt.

Die EP 0 681 989 A1 beschreibt ein Verfahren, bei dem Aerosole von wässrigen Lösungen, die eine Mischung der entsprechenden Metallsalze im erforderlichen stöchiometrischen Verhältnis enthalten, in einer Wasserstoff/Sauerstoff-Flamme pyrolysiert werden. Dabei wird die Flammentemperatur im Bereich von 800 bis 1100°C gehalten. Der Kontakt der Aerosole und der im Verfahren erzeugten Pulver mit Kohlenstoff oder kohlenstoffhaltigen Verbindungen oder Materialien muss dabei vermieden werden.

In der EP 0 905 104 wird ein Verfahren zur Herstellung von hochtemperatursupraleitenden Bi(Pb)SrCaCuO-haltigen Pulvern beschrieben, bei dem eine Pulvermischung, die Verbindungen des Bi, Sr, Ca, Cu sowie wahlweise Pb enthält, die sich beim Calcinieren in die jeweiligen Oxide und/oder Mischoxide umwandeln und in einem kontinuierlichen Drehrohrofen kontinuierlich calciniert. Die so hergestellten Pulver können als Vorprodukt für die Herstellung von hochtemperatursupraleitenden Drähten, Bändern, Stäben, Rohren, Hohl- und Vollkörpern verwendet werden.

Zusammenfassend ist festzustellen, dass die bekannten Spraypyrolyseverfahren für die Herstellung von Hochtemperatur-Supraleiter Pulvern folgende Nachteile aufweisen: Es kommt zur Bildung unerwünschter Hochtemperaturphasen. Die Verdampfung flüchtiger Oxide kann zu Stöchiometrie-Schwankungen bzw. zu unzureichender Reproduzierbarkeit der chemischen Zusammensetzung führen. Die Verfahren führen zu einer unzureichenden Umsetzung zum Mischoxid bzw. zu einem hohen Restnitratgehalt. Es kommt zur Bildung grobkörniger und harter Agglomerate und zu pulverigen Ablagerungen an der Reaktorwand, die in zeitlichen Abständen entfernt werden müssen, wodurch der Betrieb der Anlagen ggf. unterbrochen werden muss, und die oft die Quelle harter Agglomerate sind. Ferner besteht durch die begrenzte Reaktorgeometrie nur unzureichend die Möglichkeit zur Aufskalierung.

Die DD 245 647 und die DD 245 649 beschreiben Verfahren zur Herstellung silikatischer Stoffe bzw. einphasiger Oxide, bei dem flüssige Kieselsole bzw. flüssige oder gelöste Metallverbindungen mit organischen Liganden in einer pulsierenden Verbrennung in einem Schwingfeuerreaktor zerstäubt und thermisch behandelt werden. Dieses Verfahren erzeugt hochdisperse Kieselgele bzw. Oxide mit gezielten Partikelgrößen, Oberflächengrößen und Oberflächenstrukturen.

Aufgabe der vorliegenden Erfindung ist es, ein technisch und wirtschaftlich vorteilhaftes Verfahren zur Herstellung eines multinären, mindestens ternären Metalloxidpulvers bereit zu stellen, das sich zur Verwendung als Vorläufer von Hochtemperatur-Supraleitern eignet, und das die Nachteile des Standes der Technik nicht aufweist.

Diese Aufgabe wird erfindungsgemäß durch ein Verfahren gelöst, bei dem ein Gemisch der entsprechenden Metallsalze und/oder Metalloxide und/oder Metalle in fester Form oder in Form einer Lösung oder einer Suspension im erforderlichen stöchiometrischen Verhältnis enthaltend mindestens drei Elemente, ausgewählt aus Cu, Bi, Pb, Y, Tl, Hg, La, Lanthanide, Erdalkalimetalle, in einen Pulsationsreaktor mit einer pulsierenden, aus einer flammenlosen Verbrennung resultierenden Gasströmung eingebracht wird und teilweise oder vollständig zum multinären Metalloxid umgesetzt wird.

Das erfindungsgemäße Verfahren zeichnet sich dadurch aus, dass ein Gemisch der entsprechenden Metallsalze, Metalloxide oder Metalle in einen Pulsationsreaktor eingebracht wird und zum multinären d.h. zum mehrere Elemente enthaltenden Metalloxid umgesetzt wird. Dabei werden die Metalle bzw. Metallverbindungen im erforderlichen stöchiometrischen Verhältnis eingesetzt und enthalten mindestens drei Elemente, vorzugsweise drei, vier oder fünf Elemente, ausgewählt aus der Gruppe Cu, Bi, Pb, Y, Tl, Hg, La, Lanthanide, Erdalkalimetalle. Das erhaltene feinteilige, mehrere Elemente enthaltende Metalloxidpulver ist zur Verwendung bei der Herstellung von Hochtemperatur-Supraleiter-Keramiken geeignet.

Überraschenderweise werden mit dem erfindungsgemäßen Verfahren trotz extrem kurzer Verweilzeiten im Reaktor multinäre Oxide mit hohem Grad der Umsetzung erhalten. Das Verfahren zeigt eine hohe Reaktivität zur Zielphasenbildung und gute Reproduzierbarkeit der Zusammensetzung. Die erfindungsgemäß hergestellten Partikel weisen geringe Partikelgrößen auf und bei der Herstellung entstehen keine groben bzw. harten Agglomerate.

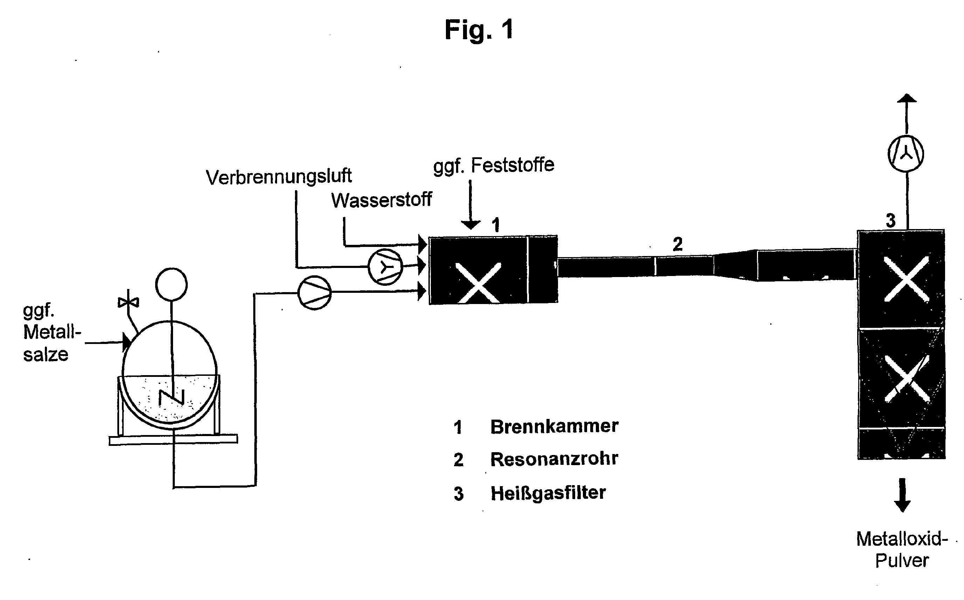

Das Wirkprinzip des Pulsationsreaktors gleicht dem eines akustischen Hohlraumresonators, der aus einer Brennkammer, einem Resonanzrohr und einem Zyklon bzw. Filter zur Pulverabscheidung besteht. Ein erfindungsgemäßer Pulsationsreaktor ist in Figur 1 dargestellt. Er besteht aus einer Brennkammer (1), an die sich abgasseitig ein Resonanzrohr (2) mit einem gegenüber der Brennkammer deutlich verringertem Strömungsquerschnitt anschließt. Der Brennkammerboden ist mit einem oder mehreren Ventilen zum Eintritt der Brenngase ausgestattet. Zur Abscheidung der Pulver aus dem Gasstrom dient ein geeigneter Filter (3) für Feinstpartikel.

Das in die Brennkammer eintretende Brenngasgemisch wird gezündet, verbrennt sehr schnell und erzeugt eine Druckwelle in Richtung des Resonanzrohres, da die Gaseintrittsseite durch aerodynamische Ventile bei Überdruck weitgehend verschlossen wird. Durch das in das Resonanzrohr ausströmende Gas wird ein Unterdruck in der Brennkammer erzeugt, so dass durch die Ventile neues Gasgemisch nachströmt und selbst zündet. Dieser Vorgang des Ventil-Schließens und Öffnens durch Druck und Unterdruck erfolgt selbstregelnd periodisch. Der pulsierende flammenlose Verbrennungsprozess in der Brennkammer setzt mit der Ausbreitung einer Druckwelle im Resonanzrohr Energie frei und regt dort eine akustische Schwingung an. Derartige pulsierende Strömungen sind durch einen hohen Turbulenzgrad gekennzeichnet. Die Pulsationsfrequenz kann über die Reaktorgeometrie eingestellt und über die Temperatur gezielt variiert werden. Dies bereitet dem Fachmann keinerlei Schwierigkeiten. Bevorzugt pulsiert die aus der flammenlosen Verbrennung resultierende Gasströmung mit 20 bis 150 Hz, insbesondere bevorzugt mit 30 bis 70 Hz.

Bezüglich des Brennkammerdruckes und der Gasgeschwindigkeit im Resonanzrohr liegen instationäre Verhältnisse vor, die einen besonders intensiven Wärmeübergang, d.h. eine sehr schnelle und umfangreiche Energieübertragung vom pulsierenden heißen Gasstrom zu den Festkörperpartikeln gewährleisten. Dadurch gelingt es erfindungsgemäß, bei sehr kurzen Verweilzeiten im Millisekundenbereich einen sehr großen Reaktionsfortschritt zu erzielen. Überraschenderweise kann unter diesen Bedingungen auch bei multinären Stoffsystemen ein hoher Grad der definierten Mischoxidbildung erreicht werden. Vorteilhafterweise ist eine Aufskalierung des erfindungsgemäßen Verfahrens möglich.

Als Brenngas eignet sich grundsätzlich jedes Gas, das zur Heißgaserzeugung geeignet ist. Dieses wird gegebenenfalls im Gemisch mit Sauerstoff eingesetzt. Vorzugsweise wird Erdgas und/oder Wasserstoff im Gemisch mit Luft oder gegebenenfalls Sauerstoff verwendet. Denkbar sind aber beispielsweise auch Propan oder Butan. Im Unterschied zu Pyrolyseverfahren z.B. im Permeationsreaktor dient damit die Verbrennungsluft auch als Trägergas für den Stofftransport im Reaktor.

Das Gemisch der entsprechenden Metalle und/oder Metallverbindungen kann entweder in fester Form, insbesondere in Form eines Pulvers, oder in Form einer Lösung oder Suspension in den Reaktor eingebracht werden. Zu kalzinierende feste Stoffgemische können mittels Injektor in den Gasstrom gefördert werden, wobei die pulsierende turbulente Strömung zu einer feinen Verteilung des Materials im Reaktionsraum führt. Lösungen oder Suspensionen werden mittels einer oder mehrerer Düsen, vorzugsweise mittels Zweistoffdüse feinst verteilt eingebracht. Dadurch erfolgt eine sehr schnelle Entwässerung bzw. thermische Zersetzung der Reaktanten und die verbleibenden Festkörperpartikel können im heißen Gasstrom zum Mischoxid reagieren.

In einer bevorzugten Ausführungsform des erfindungsgemäßen Verfahrens wird das Gemisch in Form einer wässerigen Salzlösung oder Suspension von Nitraten, Acetaten, Citraten, Lactaten, Tartraten, Chloriden, Hydroxiden, Carbonaten und/oder Oxalaten der entsprechenden Metalle eingebracht. Besonders bevorzugt werden Salzlösungen der entsprechenden Metalle mit dem gleichen Gegenanion verwendet.

Erfindungsgemäß wird das Gemisch in die aus der flammenlosen Verbrennung resultierende heiße Gasströmung des Pulsationsreaktors eingebracht. Dadurch verdampft bzw. verbrennt das gegebenenfalls vorhandene Lösungsmittel und Metallsalz- bzw. Metalloxidpartikel bilden sich, die dann im weiteren Verlauf der Reaktion durch thermische Umsetzung, Oxidation und/oder Reduktion ganz oder teilweise zum multinären Metalloxid ungesetzt werden.

Bei dem erfindungsgemäßen Verfahren kann das Gemisch entweder direkt in die Brennkammer des Pulsationsreaktors oder in das an die Brennkammer anschließende Resonanzrohr des Pulsationsreaktors eingebracht werden. Das Einbringen in das Resonanzrohr hat den Vorteil, das dadurch der Verbrennungsprozess von den chemischen Festkörperreaktionen getrennt wird.

Durch die flammenlose Verbrennung und die turbulenten Strömungsverhältnisse liegt im Reaktionsraum eine homogene Temperaturverteilung vor, so dass die eingebrachten Rohstoffe einer gleichartigen thermischen Behandlung unterliegen. Damit werden lokale Überhitzungen und Wandablagerungen vermieden, die bei den Sprühpyrolyseverfahren zur Bildung grober und harter Agglomerate führen. Die aus der pulsierenden Verbrennung resultierende Gasströmung weist im Pulsationsreaktor Strömungsturbulenzen auf, deren Turbulenzgrad in einer bevorzugten Ausführungsform 5 bis 10-fach über dem Turbulenzgrad einer stationären Strömung liegt. Die Temperatur der Gasströmung in der Brennkammer des Pulsationsreaktors liegt vorzugsweise oberhalb von 650°C, insbesondere oberhalb vom 800°C. Bei keramischer Auskleidung der Brennkammer und gegebenenfalls des Resonanzrohres besteht die Möglichkeit das erfindungsgemäße Verfahren auch bei sehr hohen, mit anderen Verfahren nicht realisierbaren Temperaturen in der Gasströmung durchzuführen.

Die im Reaktor erzeugten Partikel werden mit einer geeigneten Abscheideeinrichtung, deren Auswahl dem Fachmann keinerlei Schwierigkeiten bereitet, wie beispielsweise einem Gaszyklon, einem Oberflächen- oder einem Elektrofilter, von der Gasströmung abgetrennt.

Das Reaktionsgas wird vor seinem Eintritt in den Abscheider auf die je nach Filtertyp erforderliche Temperatur abgekühlt. Dies erfolgt durch einen Wärmetauscher und/oder durch Einleiten von Kühlgasen in den Abgasstrom. Als besonderer Vorteil des erfindungsgemäßen Verfahrens gilt, dass anstelle von Heißgasfiltern kostengünstige Hochleistungsschwebstofffilter mit vergleichsweise hohen spezifischen Filterflächen und Durchsatzleistungen angewendet werden können. Durch Einleiten CO₂-freier Kühlgase kann Pulver mit besonders niedrigem Restkohlenstoffgehalt hergestellt werden. Mittels Variation des Sauerstoffpartialdruckes bei der Einleitung der Kühlgase kann die Phasenzusammensetzung des Pulvers beeinflusst werden.

In einer Variante des erfindungsgemäßen Verfahrens kann das eingesetzte Gemisch der entsprechenden Metalle bzw. Metallverbindungen zusätzlich Dotierungen in Form gelöster Salze und/oder dispergierter Feststoffe enthalten. Diese Dotierungen werden dem Gemisch in geringen Mengen, d.h. bis maximal 5 Gew.-%, vorzugsweise bis zu 1 Gew.-% des Gemisches, zugesetzt, um gezielt bestimmte Eigenschaften des herzustellenden multinären Metalloxidpulvers zu beeinflussen. Beispielsweise kann durch Dotierungen die Kristallitgröße von Sekundärphasen, die als Pinningzentren wirken, begrenzt werden oder es können die mechanischen Eigenschaften des Bulkmaterials verbessert werden. Unter der Kristallitgröße ist die Größe des kristallographisch einheitlichen Bereich eines Pulverpartikels zu verstehen und ein Pinningzentrum ist ein Haftzentrum für den Magentischen Fluss in Supraleitern (z.B. an nicht supraleitenden Sekundärphasen). Als Dotierung werden ein oder mehrere der Elemente ausgewählt aus der Gruppe Ib z.B. Ag, aus der Gruppe IIb z.B. Zn, aus der Gruppe IVa z.B. Sn, aus der Gruppe IVb z.B. Zr, und/oder aus der Gruppe Vllb des Periodensystems z.B. Mn verwendet.

In einer weiteren Variante des erfindungsgemäßen Verfahrens kann das Metalloxidpulver im Anschluss an die Umsetzung im Pulsationsreaktor einer thermischen Nachbehandlung im Temperaturbereich von 500 bis 960°C, vorzugsweise von 550 bis 800°C, unterzogen werden. Die Auswahl einer geeigneten Art der Nachkalzination in Abhängigkeit von der Pulverart, gewünschter Phasenzusammensetzung und Anwendung bereitet dem Fachmann keinerlei Schwierigkeiten. Insbesondere bevorzugt wird die Nachkalzination in einer Pulverschüttung in einem Kammer-, Rohr-, Durchschub-, Band- oder Drehrohrofen oder in einem Wirbelbett. Dabei sind die Bedingungen so einzustellen, dass einerseits die gewünschte Phasenzusammensetzung erreicht wird, andererseits aber keine Bildung harter Agglomerate durch Sintern oder Verschmelzung von Primärkristalliten eintritt. Im BedarFsfalle wird das Pulver einer Mahlung mittels Luftstrahlmühle, Mahlkörpermühle, Prallmühle oder anderen Mahlaggregaten unterzogen.

Bevorzugt sind erfindungsgemäße Verfahren, bei denen die entsprechenden Metalle bzw. Metallverbindungen aus einer der nachfolgenden Zusammensetzungen ausgewählt werden: Bi-EA-Cu, (Bi,Pb)-EA-Cu, Y-EA-Cu, (Y,SE)-EA-Cu, TI-EA-Cu, (TI,Pb)-EA-Cu oder TI-(Y,EA)-Cu, wobei EA für Erdalkalimetallelemente, insbesondere für Ba, Ca und/oder Sr, und SE für Seltenerdmetalle steht.

### Beispiel 1:

Es wird ein Gemisch von wässrigen Nitratlösungen der Elemente Bi, Pb, Sr, Ca und Cu gemäß der Stöchiometrie Bi_{1,75} Pb_{0,35} Sr_{1,98} Ca_{2,0} Cu₃ Oₓ hergestellt, wobei der Gesamtsalzgehalt der Mischnitratlösung 40% beträgt.

Die Geometrie des Pulsationsreaktors ist definiert durch das Verhältnis Brennkammer-Länge zu Brennkammer-Durchmesser gleich 2,2 und durch das Verhältnis Resonanzrohr- Länge zu Resonanzrohr-Durchmesser gleich 33. Mittels Zweistoffdüse wird die Mischnitratlösung in den vorderen Abschnitt des Resonanzrohres als Aerosol eingebracht. Die verfahrenstechnischen Parameter Brennstoffmenge (Wasserstoff) V_{H2}, Verbrennungsluftmenge V_{VL} werden entsprechend der eingedüsten Mischnitratlösung M so gewählt, dass sich im Resonanzrohr die gewünschte Reaktionstemperatur von 700°C einstellt: V_{H2} = 2,5 kg/h; V_{VL}= 195 kg/h; M= 10 kg/h. Die Rauchgase am Ende des Resonanzrohres enthalten 16,9 % O₂, 0,09%, CO₂ und 0,24% NO.

Die Pulverabscheidung erfolgt mittels Kassettenfilter mit einer Filterfläche von 24 m² und maximaler Temperaturbelastbarkeit von 130°C.

### Eigenschaften des hergestellten Pulvers Bi_{1,75} Pb_{0,35} Sr_{1,98} Ca_{2,0} Cu₃ Oₓ:

- mittlere Korngröße 0,15 µm
- spezifische Oberfläche 9,4 m²/g
- Restnitratgehalt: 6,0%

Es erfolgt eine 8-stündige Nachkalzination in einem Kammerofen bei einer Temperatur von 810°C, bei der das multinäre Metalloxidpulver in Ag-Schiffchen mit einer maximalen Schütthöhe von 4 cm eingefüllt ist. Dabei wird der Nitratgehalt der Proben auf Werte < 100 ppm abgesenkt und die gewünschte Phasenzusammensetzung des hergestellten multinären Metalloxidpulvers eingestellt.

### Beispiel 2:

Ein Stoffgemisch gemäß Beispiel 1 wird axial in die Brennkammer des Pulsationsreaktors eingedüst. Mit V_{H2} = 3,1 kg/h; V_{VL}= 195 kg/h; M= 10 kg/h wird eine Reaktortemperatur von 900°C eingestellt. Die Rauchgase enthalten 14,6 % O₂, 0,08%, CO₂ und 0,28% NO. Alle anderen Parameter entsprechen denen von Beispiel 1.

Eigenschaften des hergestellten Pulvers Bi_{1,75} Pb_{0,35} Sr_{1,98} Ca_{2,0} Cu₃ Oₓ:
- mittlere Korngröße 0,24 µm
- spezifische Oberfläche 8,4 m²/g
- Restnitratgehalt: 4,4%

Durch eine 8-stündige Nachkalzination in einem Kammerofen bei einer Temperatur von 800°C, bei der das multinäre Metalloxidpulver in Ag-Schiffchen mit einer maximalen Schütthöhe von 4 cm eingefüllt ist, wird der Nitratgehalt der Proben auf Werte < 100 ppm abgesenkt und die gewünschte Phasenzusammensetzung des hergestellten multinären Metalloxidpulvers eingestellt.

### Beispiel 3:

Ein Gemisch von Chloriden der Elemente Y, Ba, Cu wird entsprechend dem stöchiometrischen Verhältnis Y_{1,5} Ba₂ Cu₃ in die Brennkammer des Reaktors gemäß Beispiel 1 eingedüst. Mit V_{H2} = 1,0 kg/h; V_{VL} = 75 kg/h; M= 3,0 kg/h wird eine Reaktortemperatur von 900°C eingestellt.

### Pulvereigenschaften:

- mittlere Korngröße 70 nm
- spezifische Oberfläche 12 m²/g
- Restchloridgehalt: 2,5%

Die Nachkalzination erfolgt 4 Stunden bei 710°C in einem Kammerofen. Hierdurch wird der Restchloridgehalt auf < 50 ppm abgebaut, ohne die Sinterreaktivität des Pulvers zu vermindern.

## Patentansprüche

1. Verfahren zur Herstellung eines feinteiligen, multinären Metalloxidpulvers, das sich zur Verwendung als Vorläufer von Hochtemperatur-Supraleitern eignet,
**dadurch gekennzeichnet, dass** ein Gemisch der entsprechenden Metallsalze und/oder Metalloxide und/oder Metalle in fester Form oder in Form einer Lösung oder einer Suspension im erforderlichen stöchiometrischen Verhältnis enthaltend mindestens drei Elemente,
ausgewählt aus Cu, Bi, Pb, Y, TI, Hg, La, Lanthanide, Erdalkalimetalle, in einen Pulsakionsreaktor mit einer pulsierenden, aus einer flammenlosen Verbrennung resultierenden Gasströmung eingebracht wird
und teilweise oder vollständig zum multinären Metalloxid umgesetzt wird.

2. Verfahren nach Anspruch 1,
**dadurch gekennzeichnet, dass** als Gemisch eine wässrige Salzlösung oder -suspension von Nitraten, Acetaten, Citraten, Lactaten, Tartraten, Chloriden, Hydroxiden, Carbonaten und/oder Oxalaten eingebracht wird.

3. Verfahren nach mindestens einem der vorhergehenden Ansprüche,
**dadurch gekennzeichnet, dass** das Gemisch direkt in die Brennkammer des Pulsationsreaktors oder in das an die Brennkammer anschließende Resonanzrohr des Pulsationsreaktors eingebracht wird.

4. Verfahren nach mindestens einem der vorhergehenden Ansprüche,
**dadurch gekennzeichnet, dass** die aus der flammenlosen Verbrennung resultierende Gasströmung im Pulsationsreaktor mit 20 bis 150 Hz, insbesondere mit 30 bis 70 Hz, pulsiert.

5. Verfahren nach mindestens einem der vorhergehenden Ansprüche,
**dadurch gekennzeichnet, dass** die aus der flammenlosen Verbrennung resultierende Gasströmung im Pulsationsreaktor Strömungsturbulenzen aufweist, deren Turbulenzgrad 5-10-fach über demjenigen einer stationären Strömung liegt.

6. Verfahren nach mindestens einem der vorhergehenden Ansprüche,
**dadurch gekennzeichnet, dass** die Gasströmung in der Brennkammer des Pulsationsreaktors Temperaturen oberhalb vom 650°C, insbesondere oberhalb von 800°C, aufweist.

7. Verfahren nach mindestens einem der vorhergehenden Ansprüche,
**dadurch gekennzeichnet, dass** das Gemisch Dotierungen in Form gelöster Salze und/oder dispergierter Feststoffe eines oder mehrerer der Elemente
ausgewählt aus der Gruppe Ib des Periodensystems, insbesondere Ag, der Gruppe IIb, insbesondere Zn, der Gruppe IVa, insbesondere Sn, der Gruppe IVb, insbesondere Zr, der Gruppe Vllb, insbesondere Mn, enthält,

8. Verfahren nach mindestens einem der vorhergehenden Ansprüche,
**dadurch gekennzeichnet, dass** das Metalloxidpulver im Anschluss an die Umsetzung im Pulsationsreaktor einer thermischen Nachbehandlung im Temperaturbereich von 500 bis 960°C, vorzugsweise von 550 bis 800°C, unterzogen wird.

9. Verfahren nach Anspruch 8,
**dadurch gekennzeichnet, dass**diethermische Nachbehandlung in einem Kammer-, Rohr-, Durchschub-, Band- oder Drehrohrofen oder in einem Wirbelschichtreaktor durchgeführt wird.

10. Verfahren nach mindestens einem der vorhergehenden Ansprüche,
**dadurch gekennzeichnet, dass** als Gemisch Verbindungen mit Elementen ausgewählt aus den folgenden Gruppen eingesetzt werden:
Bi-EA-Cu, (Bi,Pb)-EA-Cu, Y-EA-Cu, (Y,SE)-EA-Cu, TI-EA-Cu, (TI,Pb)-EA-Cu oder TI-(Y,EA)-Cu,
wobei EA für Erdalkalimetallelemente, insbesondere für Ba, Ca und/oder Sr, und SE für Seltenerdmetalle steht.

11. Verfahren nach mindestens einem der vorhergehenden Ansprüche,
**dadurch gekennzeichnet, dass** das hergestellte feinteilige Metalloxidpulver eine mittlere Kristallitgröße < 500 nm aufweist.

## Claims

1. A method for producing a finely divided, multinary metal oxide powder, which is suitable for use as precursor of high-temperature superconductors,
**characterised in that** a mixture of corresponding metal salts and/or metal oxides and/or metals in form of a solid, solution or suspension, in the requisite stoichiometric ratio containing at least three elements selected from Cu, Bi, Pb, Y, Tl, Hg, La, lanthanides, alkaline earth metals, is introduced in a pulsed reactor with a pulsing gas flow resulting from a flameless combustion and is partially or completely converted into the multinary metal oxide.

2. A method according to claim 1,
**characterised in that** an aqueous salt solution or suspension of nitrates, acetates, citrates, lactates, tartrates, chlorides, hydroxides, carbonates and/or oxalates is introduced as mixture.

3. A method according to at least one of the preceding claims,
**characterised in that** the mixture is directly introduced in the combustion chamber of the pulsed reactor or in the resonance tube of the pulsed reactor connected to the combustion chamber.

4. A method according to at least one of the preceding claims,
**characterised in that** the gas flow in the pulsed reactor resulting from flameless combustion pulses at from 20 to 150 Hz, particularly at from 30 to 70 Hz.

5. A method according to at least one of the preceding claims,
**characterised in that** the gas flow in the pulsed reactor resulting from flameless combustion comprises flow turbulences whose degree of turbulence is 5-10 times greater than that of steady-state flow.

6. A method according to at least one of the preceding claims,
**characterised in that** the gas flow in the combustion chamber of the pulsed reactor comprises temperatures above 650° C, particularly above 800° C.

7. A method according to at least one of the preceding claims,
**characterised in that** the mixture contains dopants in the form of dissolved salts and/or dispersed solids of one element or a plurality of elements
selected from group Ib of the Periodic Table, particularly Ag, from group IIb, particularly Zn, from group IVa, particularly Sn, from group IVb, particularly Zr, from group VIIb, particularly Mn.

8. A method according to at least one of the preceding claims,
**characterised in that** the metal oxide powder is subjected to thermal aftertreatment at a temperature in the range from 500 to 960° C, preferably from 550 to 800° C, after the reaction in the pulsed reactor.

9. A method according to claim 8,
**characterised in that** the thermal aftertreatment is carried out in a chamber, tube, tunnel, belt, rotary tube furnace or in a fluidised bed reactor.

10. A method according to at least one of the preceding claims,
**characterised in that** compounds with elements selected from the following groups:
Bi-EA-Cu, (Bi,Pb)-EA-Cu, Y-EA-Cu, (Y,SE)-EA-Cu, TI-EA-Cu, (TI,Pb)-EA-Cu or TI-(Y,EA)-Cu,
are employed as mixture,
whereas EA denotes alkaline earth metal elements, particularly Ba, Ca and/or Sr, and SE denotes rare-earth metals.

11. A method according to at least one of the preceding claims,
**characterised in that** the finely divided metal oxide powder produced comprises a mean crystallite size of < 500 nm.

## Revendications

1. Procédé de production d'une poudre d'oxyde métallique multinaire à particules fines, appropriée pour une utilisation comme précurseur de supraconducteurs à haute température,
**caractérisé en ce qu'** un mélange des sels métalliques et/ou oxydes métalliques et/ou métaux correspondants est chargé sous forme solide, ou sous forme d'une solution ou d'une suspension avec le rapport stoechiométrique exigé contenant au moins trois éléments, sélectionnés parmi : Cu, Bi, Pb, Y, TI, Hg, La, lanthanide, métaux alcalino-terreux, dans un réacteur pulsé avec un flux gazeux pulsé résultant d'une combustion sans flamme,
et est partiellement ou entièrement transformé en oxyde métallique multinaire.

2. Procédé selon la revendication 1,
**caractérisé en ce qu'**est chargée comme mélange une solution aqueuse saline ou une suspension de nitrates, acétates, citrates, lactates, tartrates, chlorures, hydroxydes, carbonates et/ou oxalates.

3. Procédé selon au moins une des revendications précédentes,
**caractérisé en ce que** le mélange est chargé directement dans la chambre de combustion du réacteur pulsé ou dans le tube de résonance adjacent à la chambre de combustion du réacteur pulsé.

4. Procédé selon au moins une des revendications précédentes,
**caractérisé en ce que** le flux gazeux résultant de la combustion sans flamme est pulsé entre 20 et 150 Hz, en particulier entre 30 et 70 Hz dans le réacteur pulsé.

5. Procédé selon au moins une des revendications précédentes,
**caractérisé en ce que le** flux gazeux résultant de la combustion sans flamme présente des turbulences dans le réacteur pulsé, dont le degré de turbulence est 5 à 10 fois supérieur à celui d'un flux stationnaire.

6. Procédé selon au moins une des revendications précédentes,
**caractérisé en ce que** le flux gazeux dans la chambre de combustion du réacteur pulsé présente des températures supérieures à 650°C, en particulier supérieures à 800°C.

7. Procédé selon au moins une des revendications précédentes,
**caractérisé en ce que** le mélange contient des dopages sous forme de sels dissous et/ou de matières solides dispersées d'un ou de plusieurs des éléments sélectionnés dans le groupe Ib du système périodique, en particulier Ag, le groupe IIb, en particulier Zn, le groupe IVa, en particulier Sn, le groupe IVb, en particulier Zr, le groupe VIIb, en particulier Mn.

8. Procédé selon au moins une des revendications précédentes,
**caractérisé en ce que** la poudre d'oxyde métallique est soumise à un traitement thermique consécutif à la transformation dans le réacteur pulsé, dans une plage de température de 500 à 960°C, de préférence de 550 à 800°C.

9. Procédé selon la revendication 8,
**caractérisé en ce que** le traitement thermique consécutif est effectué dans un four à moufle, à tube, à dalles glissantes, à tapis, ou dans un four rotatif, ou encore dans un réacteur de réduction en lit fluidisé.

10. Procédé selon au moins une des revendications précédentes,
**caractérisé en ce que** sont mis en oeuvre comme mélange des composés avec des éléments sélectionnés dans les groupes suivants : Bi-EA-Cu, (Bi,Pb)-EA-Cu, Y-EA-Cu, (Y,SE)-EA-Cu, TI-EA-Cu, (TI,Pb)-EA-Cu ou TI-(Y,EA)-Cu,
EA représentant des éléments de métaux alcalino-terreux, en particulier Ba, Ca et/ou Sr, et SE des métaux des terres rares.

11. Procédé selon au moins une des revendications précédentes,
**caractérisé en ce que** la poudre d'oxyde métallique à particules fines produite présente une grosseur de cristallite moyenne < 500 nm.
